# EUROPÄISCHE PATENTSCHRIFT

(11) **EP 2 351 106 B1**
(45) Veröffentlichungstag und Bekanntmachung des Hinweises auf die Patenterteilung: **02.10.2019**
(21) Anmeldenummer: 09804223.7
(22) Anmeldetag: 12.10.2009
(51) Int. Cl.: H01L 31/05, H02S 20/23

(54) **SOLARMODULSYSTEM**
SOLAR MODULE SYSTEM
SYSTÈME DE MODULE SOLAIRE

(30) Priorität: 16.10.2008 AT 16252008
(43) Veröffentlichungstag der Anmeldung: 03.08.2011
(73) Patentinhaber: Rainer, Hans-Peter, 8591 Maria Lankowitz (AT)
(72) Erfinder: Rainer, Hans-Peter, 8591 Maria Lankowitz (AT)
(74) Vertreter: Wirnsberger, Gernot
(86) Internationale Anmeldenummer: PCT/AT2009/000399
(87) Internationale Veröffentlichungsnummer: WO 2010/042964

(56) Entgegenhaltungen:
- EP-A2- 0 793 278
- EP-A2- 1 418 627
- EP-A2- 1 798 776
- WO-A2-2008/073905
- DE-A1- 10 317 020
- ES-A1- 2 281 258
- FR-A1- 2 915 345
- JP-A- 10 131 440
- US-A- 4 582 953
- US-A1- 2003 177 706
- US-A1- 2008 149 170
- US-A1- 2008 223 432

## Beschreibung

Die Erfindung betrifft ein Modul eines photovoltaischen Systems, welches einen Rahmen zur Befestigung und ein Füllelement sowie elektrische Kontakte aufweist, wobei in einer besonderen Ausführung das Füllelement mindestens eine Solarzelle zur photovoltaischen Energieumwandlung umfassen kann, sowie ein Modulsystem, das zumindest zwei derartige Module enthält.

Unter Photovoltaik versteht man die direkte Umwandlung von Strahlungsenergie, vornehmlich Sonnenenergie, in elektrische Energie. Die Energieumwandlung findet mit Hilfe von Solarzellen, die zu sogenannten Solarmodulen verbunden werden, in Photovoltaikanlagen statt. Die erzeugte Energie kann entweder vor Ort direkt genutzt werden, in Akkumulatoren gespeichert oder in Stromnetze eingespeist werden.

Diese Form der Stromerzeugung war noch in den 1960er Jahren ausschließlich militärischen Anwendungen vorbehalten. Ausgelöst durch die Energiekrisen der 1970er Jahre wurden entscheidende Fortschritte in der Entwicklung von Photovoltaikzellen erzielt und diese finden mittlerweile beispielsweise Anwendung auf Dachflächen, bei Parkscheinautomaten, in Taschenrechnern, an Schallschutzwänden oder auf Freiflächen.

Meist werden photovoltaische Elemente auf Dachflächen oder an Fassaden von Gebäuden angebracht. Dazu sind im Stand der Technik die unterschiedlichsten Ausführungen bekannt:
Beispielsweise zeigt die DE 3142 129 A1 ein verstärktes photovoltaisches Solarmodul, bei dem eine Solarzelle in Kunststoff eingebettet auf einem Tragelement aufliegt. Mit der hier gezeigten Bauart, bei der die Solarzelle durch ein flächenförmiges, biegsames Element versteift wird, gelingt es, einerseits die Solarzellen vor Biegebeanspruchung zu schützen, aber dennoch das Solarmodul so flexibel zu gestalten, daß es auf gekrümmten Flächen aufgesetzt werden kann.

Aus der DE 10 2006 009 194 A1 ist eine Anordnung, bestehend aus einer tragenden Gebäudestruktur und einem Solarzellenaufbau, bekannt. Dabei werden Einheiten, die einerseits Bauteile einer tragenden Gebäudestruktur, wie Teile eines Daches oder einer Wand, enthalten, mit Bauteilen, die eine oder mehrere Solarzellen oder bereits einen verschalteten Solarzellenaufbau enthalten, zu vormontierten Montageeinheiten kombiniert. So wird auf einfache Weise eine wirtschaftlichere Montage von Photovoltaikeinheiten auf Gebäudeaußenflächen ermöglicht.

Die GB 2 431 773 A zeigt weiters ein Solarpanel geeignet für die Dachmontage. Dieses Solarpanel ist von seiner geometrischen Form her vergleichbar mit gängigen Dachziegeln und kann daher ohne zusätzlich erforderliche Unterkonstruktion direkt anstelle der Dachziegel in bestehende Dächer eingebaut werden. Das Solarpanel ist aus Glas aufgebaut, die Solarzelle wird zum Schutz vor Witterungseinflüssen auf die Rückseite des Solarpanels aufgeklebt und wird vom Sonnenlicht durch das gläserne Solarpanel hindurch erreicht. Jede einzelne ziegeiförmige Solarzelle ist mit einem freien Kabelanschluss samt Kontaktstecker ausgestattet, der mit einem Stromleiter zur Abgabe der umgewandelten elektrischen Energie verbunden wird. Das Dokument US20080149170 zeigt ein PV Modul, das elektrische Kontakte aufweist.

Nachteilig am derzeitigen Stand der Technik derartiger Photovoltaik-Module für die Befestigung an Gebäuden ist, daß diese meist nur durch eine zusätzlich erforderliche Befestigungskonstruktion beispielsweise auf Dachflächen montiert werden können, was zumindest das äußere Erscheinungsbild eines Gebäudes beeinträchtigt. Oftmals ist auch ein Austausch von einzelnen, defekten Modulen, durch deren Baugröße oder durch die Art und Weise der Befestigungskonstruktion bedingt, gar nicht oder nur sehr aufwendig möglich. Derartige Module sind meist, um keine zusätzliche Windangriffsfläche zu bieten, direkt an der Gebäudeaußenfläche ohne Abstand zum Gebäude montiert und damit nicht unterlüftet. Photovoltaik-Module, die von ihrer Formgestaltung her einem standardisierten Gebäudebauteil entsprechen und diesen ersetzen können, wie beispielsweise Module in Dachziegelform, sind teuer in der Anschaffung und meist schwerer als die dadurch ersetzten Standardbauteile. Damit sind deren Einsatzmöglichkeiten stark eingeschränkt.

Aufgabe der vorliegenden Erfindung ist es, für Photovoltaik-Module alle genannten Nachteile des bekannten Stands der Technik zu überwinden und dafür Lösungen zu bieten. Es gilt, mit der vorliegenden Erfindung eine formschöne, kostengünstige und äußerst flexible Modulbauweise zur kompletten, durchgehenden Gestaltung einer oder mehrerer Außenflächen eines Gebäudes mit photovoltaischen Modulen anzubieten. Die Erfindung soll sowohl bei der Ausstattung bereits bestehender Gebäude mit photovoltaischen Einrichtungen zur Energieumwandlung, als auch bei der Neuerrichtung von Gebäuden Anwendung finden und einen Beitrag zur verstärkten Nutzung von Sonnenenergie als alternative und nachhaltige Energieform liefern. Diese Aufgabe wird gelöst mit einem Modul mit den Merkmalen des Anspruchs 1.

Erfindungsgemäß weist ein Modul eines photovoltaischen Systems, welches einen Rahmen zur Befestigung und ein Füllelement sowie elektrische Kontakte aufweist, im Rahmen mindestens zwei elektrische Kontakte auf und das Modul kann an diesen elektrischen Kontakten mit einem oder mehreren benachbarten Modulen leitend verbunden werden. Damit sind die elektrischen Kontakte geschützt im Rahmen positioniert und gewährleisten eine dauerhafte leitende Verbindung zwischen den Modulen ohne unerwünschte Störungen.

Vorteilhafterweise umfasst ein Modul eines photovoltaischen Systems ein Füllelement mit mindestens einer Solarzelle zur photovoltaischen Energieumwandlung, wobei die Solarzelle elektrische Anschlüsse aufweist und diese mit den elektrischen Kontakten im Rahmen des Moduls leitend verbunden sind. Diese Solarzellen sind meist als monokristalline oder multikristalline Siliziumsolarzellen in Waferform aufgebaut und damit meist anthrazitgrau gefärbt. Andersfärbige Solarzellen, beispielsweise mit ziegelroter Oberfläche zur Anpassung an Fassaden, befinden sich derzeit noch in Entwicklung und haben momentan noch einen geringeren Wirkungsgrad im Vergleich zu den Siliziumsolarzellen, sollen aber später ebenfalls zur Lösung der hier gestellten Aufgaben eingesetzt werden können.

Bei einer Ausführungsform eines erfindungsgemäßen Moduls eines photovoltaischen Systems ist das Füllelement mechanisch bearbeitbar, wie beispielsweise bohrbar oder sägbar. Damit können Module beispielsweise an Lüftungsöffnungen, Kamine, Dachfenster, Giebel oder andere Ausnehmungen eines Gebäudes entsprechend angepasst werden.

Vorteilhafterweise ist ein Modul eines photovoltaischen Systems dadurch gekennzeichnet, daß die elektrischen Kontakte des Moduls miteinander durch Stromleiter verbunden sind, wobei diese Stromleiter vorzugsweise im Rahmen des Moduls integriert sind. Damit werden kurze Leitungslängen zwischen den einzelnen benachbarten Modulen ermöglicht.

Eine zweckmäßige Ausführungsform eines derartigen Moduls eines photovoltaischen Systems enthält Einzelbefestigungselemente zur unmittelbaren, lösbaren Befestigung des Moduls an einer Unterkonstruktion, wie beispielsweise an einer Außenfläche eines Gebäudes. Mit diesen Einzelbefestigungselementen können die Module zuerst an der Unterkonstruktion sicher befestigt werden und erleichtern damit die Montagearbeiten. Die Einzelbefestigungselemente können auch geometrisch ausgeformte Montagehilfen wie Leisten oder Haken vorsehen, damit die Lage und Ausrichtung der Module vor ihrer Befestigung einfach justiert werden können.

Eine weitere vorteilhafte Ausführungsform eines Moduls eines photovoltaischen Systems ist dadurch gekennzeichnet, daß Doppelbefestigungselemente zur unmittelbaren, lösbaren Befestigung des Moduls mit einem benachbarten Modul an einer Unterkonstruktion, wie beispielsweise an einer Außenfläche eines Gebäudes, vorhanden sind.

Zur Lösung der erfindungsgemäßen Aufgabe kann ein Modul eines photovoltaischen Systems auch in einer Ausführungsform Befestigungselemente zur verschiebbaren oder verdrehbaren Lagerung des Moduls beinhalten. Damit können derartige Module beispielsweise auch an Fassaden von Gebäuden wie Lamellen beweglich angebracht werden und damit neben ihrer Funktion der Energieumwandlung bzw. Energieerzeugung auch für die Gebäudebeschattung dienen.

Vorteilhafterweise ist ein Modul eines photovoltaischen Systems dadurch gekennzeichnet, daß jedes Modul mindestens eine Belüftungsöffnung zur Hinterlüftung umfasst. Diese Belüftungsöffnung kann entweder am Rahmen des Moduls angebracht sein oder es sind die Befestigungselemente derart ausgebildet, daß bei der Montage des Moduls eine schmale Fuge gegenüber der Unterkonstruktion und den benachbarten Modulen frei bleibt und somit ein Belüftungsschlitz zur Hinterlüftung des jeweiligen Moduls vorhanden ist.

In einer besonderen Ausführungsform eines Moduls eines photovoltaischen Systems besteht der Rahmen des Moduls aus einem Verbundwerkstoff, vorzugsweise aus einem Holz-Kunststoff-Verbundwerkstoff (engl.: WPC; Wood Plastic Composites). Vorteilhafterweise sind derartige Verbundwerkstoffe witterungs-, UV- und schädlingsbeständig, weisen die erforderliche Festigkeit bei statischer und dynamischer Belastung auf und ermöglichen die Konstruktion leichter und schlanker Rahmen und Befestigungselemente für derartige Module.

Weiters wird die erfindungsgemäße Aufgabe durch Einführen eines Modulsystems gelöst, welches dadurch gekennzeichnet ist, daß es zumindest zwei Module mit einem oder mehreren der zuvor genannten Merkmale enthält. Mit diesem Modulsystem sind größere Flächen an Gebäuden durchgängig zu gestalten.

Vorteilhaft werden bei einem derartigen Modulsystem zu seiner Befestigung zumindest zwei Module miteinander zusammengesteckt und jeweils zwei Module an mindestens einem Befestigungselement entweder nebeneinander oder einander teilweise überlappend gemeinsam befestigt.

Erfindungsgemäß ist ein solches Modulsystem dadurch gekennzeichnet, daß es unterschiedlich große Module beinhaltet, wobei die Fläche der kleinen Module in einem ganzzahligen Verhältnis, beispielsweise im Verhältnis 4:1 oder 3:1, vorzugsweise im Verhältnis 2:1, zur Fläche eines großen Moduls steht.

Damit stehen im Modulsystem unterschiedlich große Module mit Füllelementen, die an die jeweiligen Gebäudegegebenheiten angepasst werden können, zur Verfügung. Module, deren Füllelemente ohne Ausnehmungen versehen sind, enthalten vorzugsweise Solarzellen zur Energieumwandlung. Durch die leitenden Verbindungen zwischen den Rahmen der Module werden damit Module mit Füllelementen, die Ausnehmungen beispielsweise für Fenster oder Lüftungseinrichtungen eines Gebäudes aufweisen und damit keine Solarzellen enthalten, vergleichbar mit Inseln in der gesamten Fläche des Modulsystems für die photovoltaische Energieumwandlung ausgenommen.

Ein derartiges Modulsystem kann auch Elemente mit Sonderformen zur Gestaltung der Außenflächen eines Gebäudes enthalten: Firstkappen, Pultdachkappen, Elemente mit Firstentlüftungsöffnungen, Kamineinfassungen, Antennenausgangselemente, Anschlusswinkel, Traufeneinlaufselemente und dergleichen. Damit ist eine komplett durchgehende Gestaltung von Dach- und Fassadenflächen eines Gebäudes möglich.

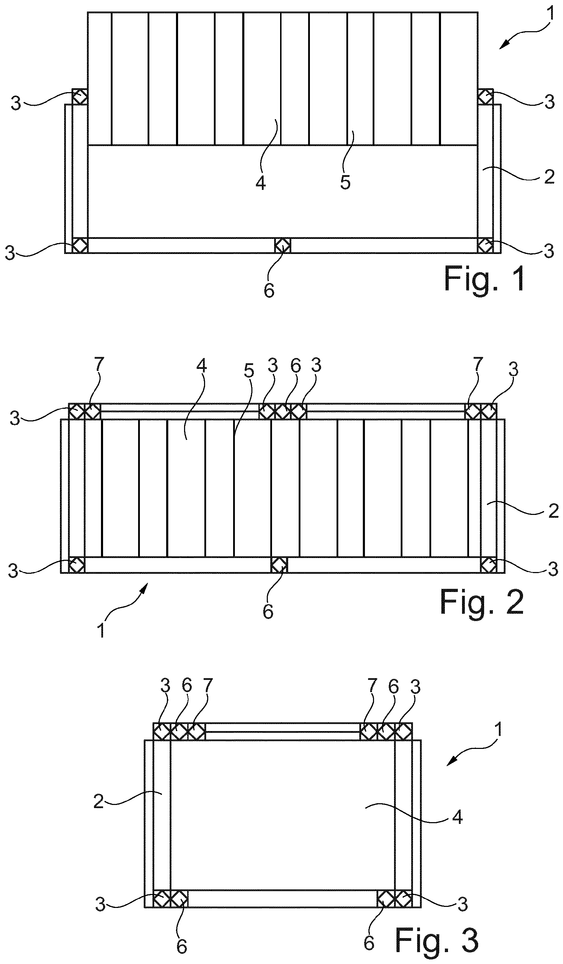

Ausführungsbeispiele einzelner Module bzw. von mehreren Modulen in einem derartigen photovoltaischen Modulsystem sind in den Abbildungen Fig. 1 bis Fig. 12 dargestellt und in der nachfolgenden Beschreibung näher erläutert.

Fig. 1 zeigt in einer schematischen Darstellung den Grundriss eines photovoltaischen Moduls 1 während des Zusammenbaus des Moduls. Das Modul besteht aus einem umlaufenden Rahmen 2, der beispielsweise wie in Fig. 1 dargestellt vier Doppelbefestigungselemente 3 aufweist. Das Füllelement 4 enthält eine Solarzelle 5, wie in der Fig. 1 und den weiteren Abbildungen Fig. 2 bis Fig. 8 jeweils durch Streifen im Füllelement gekennzeichnet ist, und befindet sich noch nicht in seiner endgültigen Einbaulage im Modul, sondern ist in Fig. 1 erst teilweise in den Rahmen 2 eingefügt. Das Füllelement 4 wird anhand einer Führung wie beispielsweise einem Montagesteg, welcher am Rahmen 2 angebracht ist, an diesem ausgerichtet und in den Rahmen eingeschoben oder eingesteckt sowie an den beiden kürzeren Seiten des Rahmens durch im Rahmen befindliche Montagefedern oder dergleichen gegenüber dem Rahmen kraftschlüssig fixiert. Das Füllelement 4 kann im Bedarfsfall wieder aus dem Rahmen 2 herausgenommen werden. In der Ansicht von Fig. 1 ist schematisch ein elektrischer Kontakt 6 mittig an der längeren Seite am Rahmen dargestellt. Mindestens ein weiterer elektrischer Kontakt ist in dieser Ansicht vom noch nicht fertig in den Rahmen 2 eingebauten Füllelement 4 verdeckt.

Fig. 2 zeigt ebenfalls in einer schematischen Darstellungsweise den Grundriss eines photovoltaischen Moduls 1, jedoch im Gegensatz zu Fig. 1 im bereits fertig zusammengebauten Zustand. Im Rahmen 2 sind an den Ecken insgesamt vier Doppelbefestigungselemente 3 vorgesehen. An der oberen Seite des Rahmens 2 sind an den Ecken zwei Einzelbefestigungselemente 7 sowie mittig an der längeren Seite des Rahmens 2 neben einem elektrischen Kontakt 6 zusätzlich zwei Doppelbefestigungspunkte 3 zur gemeinsamen Befestigung für benachbarte Module mit im Vergleich zum dargestellten Modul jeweils der halben Fläche vorgesehen. Das Füllelement 4 in Fig. 2 enthält eine Solarzelle 5. An der gegenüberliegenden, längeren Seite des Rahmens 2 ist mittig ein weiterer elektrischer Kontakt 6 vorgesehen.

Fig. 3 zeigt in einer schematischen Darstellungsweise den Grundriss eines photovoltaischen Moduls 1, wobei der Rahmen 2 an den Ecken insgesamt vier Doppelbefestigungselemente 3 und vier elektrische Kontakte 6 sowie an einer Seite zusätzlich noch zwei Einzelbefestigungselemente 7 aufweist. Das Füllelement 5 enthält keine Solarzelle. Die Fläche des Moduls 1 ist im Verhältnis 2:1 kleiner als die in Fig. 2 dargestellte Fläche. Daher sind im Vergleich zu Fig. 1 in Fig. 2 doppelt so viele, damit insgesamt vier, elektrische Kontakte 6 vorgesehen und diese sind, ebenfalls abweichend zu deren in Fig. 1 gezeigten mittigen Anordnung, jeweils am Rand an den Ecken des Moduls 1 angeordnet.

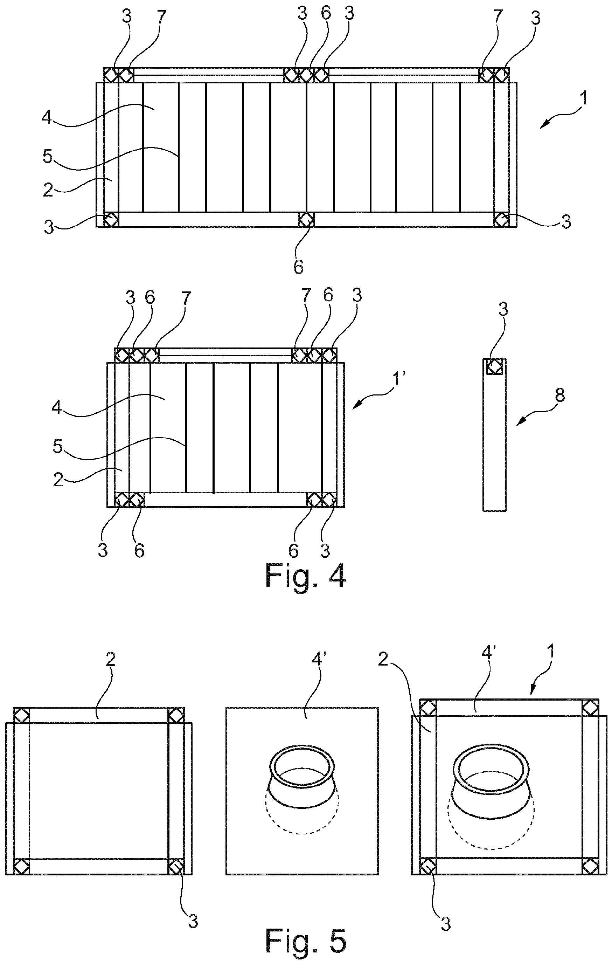

Fig. 4 zeigt in einer schematischen Darstellung jeweils im Grundriss ein größeres Modul 1 sowie darunter ein kleineres Modul 1' mit im Verhältnis zum größeren Modul halber Fläche, sowie daneben den Grundriss einer Verbindungskappe 8.

Das größere Modul 1 enthält an den Ecken angeordnet vier Doppelbefestigungselemente 3, sowie in der Mitte der längeren Seite des Rahmens 2 zwei weitere Doppelbefestigungselemente 3 zur gemeinsamen Befestigung mit benachbarten kleineren Modulen mit im Verhältnis gleicher oder halbierter Fläche. An einer längeren Seite des Rahmens sind zusätzlich zwei Einzelbefestigungselemente 7 vorgesehen. Weiters sind zwei elektrische Kontakte 6 jeweils in der Mitte der längeren Seite des Rahmens 2 angeordnet. Das Füllelement 4 enthält eine Solarzelle 5.

Auch das Füllelement 4 des in Fig. 4 dargestellten, im Verhältnis zum größeren Modul 1 um die Hälfte kleineren Moduls 1' enthält eine Solarzelle 5. Im Bereich des Rahmens 2 des kleineren Moduls 1' sind an den Ecken vier Doppelbefestigungselemente 3 sowie vier elektrische Kontakte 6 vorgesehen. Am Ende einer längeren Seite des Rahmens 2 sind weiters zwei Einzelbefestigungselemente 7 vorhanden.

Außerdem ist in Fig. 4 eine Verbindungskappe 8 schematisch dargestellt. Diese Verbindungskappe 8 wird jeweils seitlich an der kürzeren Seite eines Moduls 1 zwischen zwei benachbarten Modulen angefügt und sorgt somit für einen bündigen Abschluss und Übergang zwischen den einzelnen Modulen. Jede Verbindungskappe 8 ist mit mindestens einem Doppelbefestigungselement 3 zur gemeinsamen Verbindung mit mindestens einem benachbarten Modul ausgestattet.

Fig. 5 zeigt in einer schematischen Darstellung von links beginnend einen leeren Rahmen 2 mit jeweils an den Ecken befindlichen insgesamt vier Doppelbefestigungselementen 3. In der Mitte von Fig. 5 ist ein spezielles Füllelement 4', hier beispielsweise ein Füllelement mit einer Bohrung und einem zylindrischen Anschlussteil, der für Lüftungsauslässe eines Gebäudes geeignet ist, dargestellt. Im rechten Teil von Fig. 5 sind der links dargestellte Rahmen 2 sowie das mittig dargestellte speziell geformte Füllelement 4' in gemeinsamer Einbaulage zu einem Modul 1 vereint dargestellt.

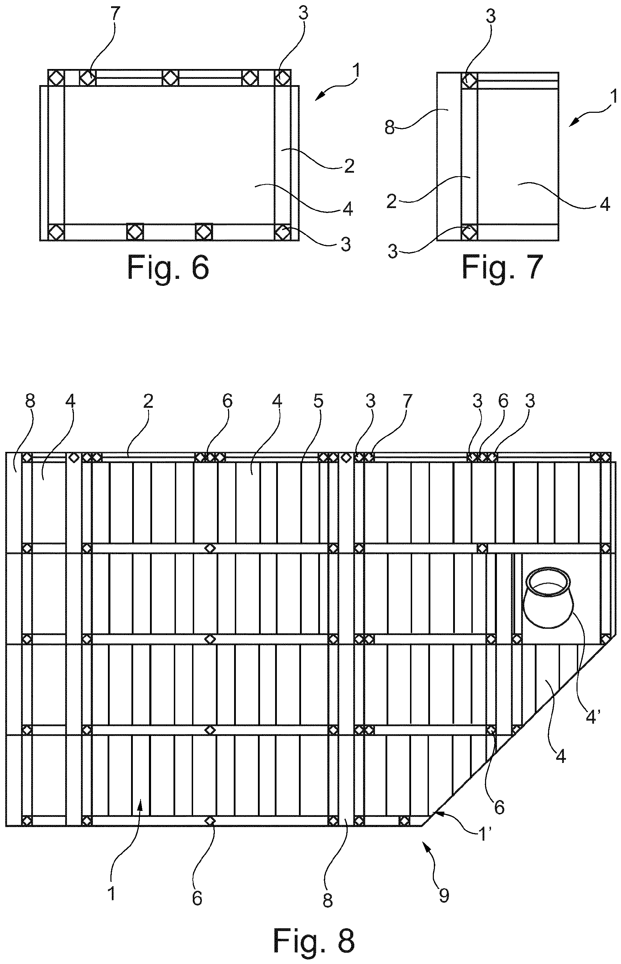

Fig. 6 zeigt im Grundriss ein kleineres Modul 1 mit einem Rahmen 2, einem Füllelement 4 und einer Vielzahl an Befestigungspunkten, die unter Umständen für spezielle Befestigungsaufgaben eines einzelnen Moduls 1 wie beispielsweise bei der Montage am Rand eines Daches oder am Rand einer Fassadenfläche eines Gebäudes erforderlich sind. So sind im dargestellten Fall an einer längeren Seite drei Einzelbefestigungselemente 7 sowie zusätzlich an den Enden derselben Seite zwei weitere Doppelbefestigungselemente 3 vorgesehen. An der gegenüberliegenden längeren Seite sind hier vier Doppelbefestigungselemente 3 vorhanden.

Fig. 7 stellt schematisch den Grundriss eines Moduls 1 passend für einen Ortgang als Abschluss einer Dachfläche an einem senkrecht stehenden Giebel dar. Dieses speziell gestaltete Modul 1 beinhaltet einen an einer von vier Seiten offenen Rahmen 2, zwei Doppelbefestigungspunkte 3 im Bereich des Rahmens, ein Füllelement 4, welches an drei Seiten mit dem Rahmen 2 verbunden ist, sowie eine Verbindungskappe 8. Da dieses Modul an die jeweiligen Gebäudeabmessungen kürzbar angepasst werden kann, sind hier keine Solarzelle und auch keine elektrischen Kontakte vorgesehen.

Fig. 8 stellt schematisch den Grundriss eines Modulsystems 9 dar, welches mehrere einzelne Module 1 bzw. 1' umfasst. Das gezeigte Modulsystem 9 könnte Teil eines Daches sein, ohne in Fig. 8 dessen Teile darzustellen. Das Modulsystem 9 beinhaltet mehrere größere Module 1 jeweils gleicher Größe, die direkt nebeneinander montiert sind und deren Rahmen 2 aneinander grenzen. An den kürzeren Seiten dieser Module 1 sind jeweils Verbindungskappen 8 montiert, die für eine glatte Oberfläche des Modulsystems sorgen und Montagefugen zwischen den einzelnen Modulen abdecken. Die größeren Module 1 haben jeweils in der Mitte ihrer längeren Seite elektrische Kontakte 6 im Bereich des Rahmens 2, an denen die als strichlierte Flächen gekennzeichneten Solarzellen 5 als Teil der Füllelemente 4 jeweils leitend miteinander verbunden sind. Die Module 1 sind wiederum ausreichend mit Einzelbefestigungselementen 7 sowie Doppelbefestigungselementen 3 zu deren sicherer Montage miteinander bzw. mit der Unterkonstruktion ausgestattet.

Um das Modulsystem 9 an individuelle Gebäudegegebenheiten, wie hier schematisch als Öffnung im Dach dargestellt oder als Verschneidung der Dachfläche mit einem Giebel angedeutet, anpassen zu können, beinhaltet das Modulsystem 9 auch Module 1', die gekürzt oder deren Füllelemente 4' mit Öffnungen versehen werden können. Bei diesen Modulen sind keine Solarzellen vorhanden.

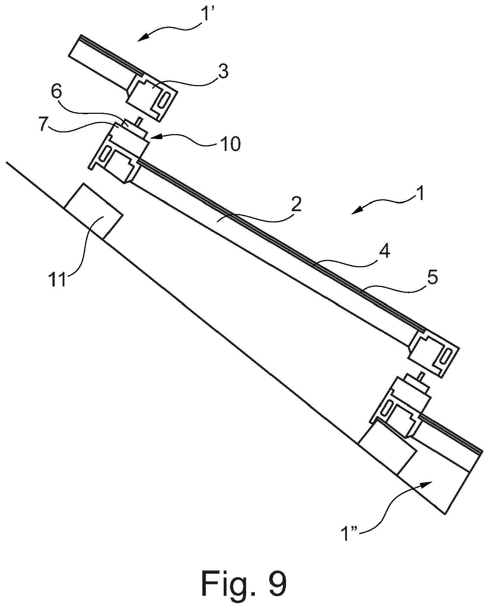

Fig. 9 stellt in einer schematischen Darstellung den Schnitt durch ein Modulsystem 9, bestehend aus mehreren Modulen 1, 1', 1'', dar. Es sind hier mehrere Dachlatten, beispielhaft für die Unterkonstruktion 11 als Teil eines Gebäudes, in geeignetem Abstand gezeigt. Die einzelnen Module 1 sind in einander überlappender Weise, vergleichbar mit herkömmlichen Dachziegeln, am Dach montiert. Dabei werden die Rahmen 2 mit Einzelbefestigungselementen 7 direkt an der Unterkonstruktion 11 befestigt, wobei einfache Haken oder Leisten als Montagehilfe dienen können. Ein nächstes, anschließendes Modul 1' wird entlang einer Seite überlappend mit einem Doppelbefestigungselement 3 gemeinsam mit dem darunter befindlichen Modul 1 befestigt, wobei eine Belüftungsöffnung 10 frei bleibt, die auch als Belüftungsschlitz ausgebildet sein kann, und damit eine Hinterlüftung der montierten Module ermöglicht wird. Mittels der elektrischen Kontakte 6 sind die Module 1, 1', 1" bzw. deren Solarzellen 5 als Teil der Füllelemente 4 miteinander leitend verbunden.

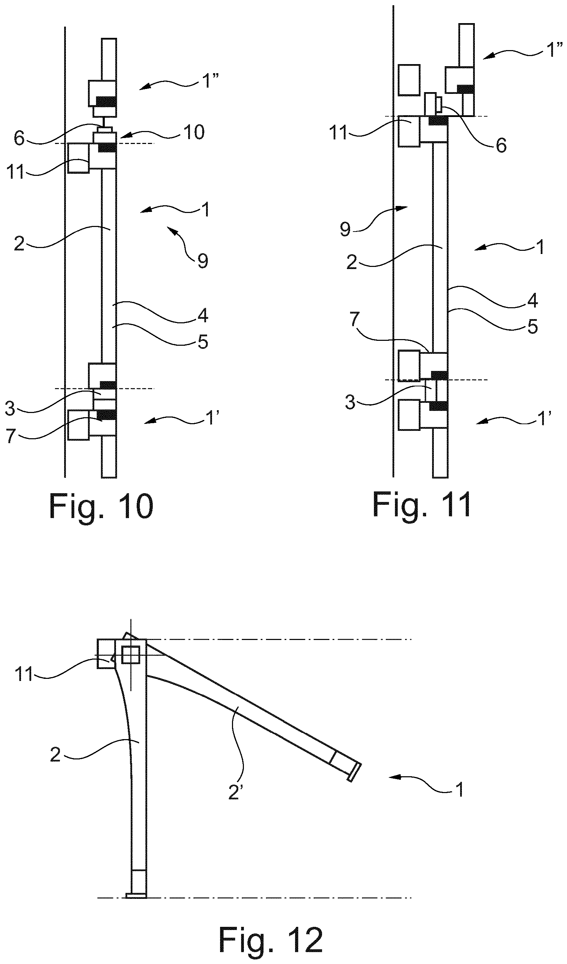

Fig. 10 und Fig. 11 zeigen unterschiedliche Montageformen derartiger Modulsysteme 9, die jeweils aus mehreren einzelnen Modulen 1, 1', 1'' bestehen und beispielsweise an einer senkrechten Fassade eines Gebäudes montiert sind. In beiden Fällen werden die Module 1, 1', 1'' jeweils mit Einzelbefestigungselementen 7 an der Unterkonstruktion 11 befestigt und an den elektrischen Kontakten 6 leitend miteinander verbunden.

Während Fig. 10 in einer Schnittdarstellung die flächig fixe Montage der Module eines Modulsystems 9 zeigt, ist in Fig. 11 in einer Schnittdarstellung die flächig austauschbare Montage eines derartigen Modulsystems 9 dargestellt. Abhängig ist die Wahl zwischen fixer und austauschbarer Montageweise der einzelnen Module von der Ausführung, der Form und Lage der Doppelbefestigungselemente 3 und der elektrischen Kontakte und deren Position am Rahmen 2 der Module 1. Die zur Verfügung stehenden Flächen der Füllelemente 4 bzw. die Flächen der Solarzellen 5 sind von der Art der Montage unabhängig. Auch die erwünschten Belüftungsöffnungen 10 sind in beiden Montageweisen vorhanden.

Fig. 12 zeigt ein weiteres Beispiel einer besonderen Montageweise eines derartigen Moduls 1. Wie schematisch in der Schnittzeichnung dargestellt, wird hier ein Modul 1 an der Unterkonstruktion 11 an einem Lager drehbar befestigt. Der Rahmen 2 des Moduls kann - je nach den Erfordernissen zur Beschattung des Gebäudes oder zur optimalen Einstellung des Moduls nach dem aktuellen Sonnenstand - verdreht werden und beispielsweise in eine verdrehte Lage 2' gebracht werden.

### Legende zu den Abbildungen:

### Bezugszeichen bzw. Bezeichnung im Text

- (1): Photovoltaisches Modul
- (2): Rahmen
- (3): Doppelbefestigungselement
- (4): Füllelement
- (5): Solarzelle
- (6): elektrischer Kontakt
- (7): Einzelbefestigungselement
- (8): Verbindungskappe
- (9): Modulsystem
- (10): Belüftungsöffnung
- (11): Unterkonstruktion, Teil eines Gebäudes

## Patentansprüche

1. Modul (1) eines fotovoltaischen Systems, welches einen Rahmen (2) zur Befestigung und ein Füllelement (4) sowie elektrische Kontakte (6) aufweist, wobei im Rahmen (2) mindestens zwei elektrische Kontakte (6) vorhanden sind und das Modul (1) an diesen elektrischen Kontakten mit einem oder mehreren benachbarten Modulen leitend verbunden werden kann, **dadurch gekennzeichnet, dass** das Modul (1) derart ausgebildet ist, dass mehrere Module (1) in einander überlappender Weise, vergleichbar mit herkömmlichen Dachziegeln, an einem Dach montierbar sind, wobei der Rahmen (2) eines Moduls (1) mit Einzelbefestigungselementen (7) direkt an einer Unterkonstruktion (11) befestigbar ist, wobei ein anschließendes Modul (1) entlang einer Seite überlappend mit einem Doppelbefestigungselement (3) gemeinsam mit einem darunter befindlichen Modul (1) an einer Unterkonstruktion (11) befestigbar ist, wobei ein Doppelbefestigungselement (3) zur unmittelbaren, lösbaren Befestigung eines Moduls (1) mit einem benachbarten Modul (1) an der Unterkonstruktion (11) eingerichtet ist und wobei eine Belüftungsöffnung (10) zur Hinterlüftung frei bleibt.

2. Modul (1) nach Anspruch 1, **dadurch gekennzeichnet, dass** das Füllelement (4) mindestens eine Solarzelle (5) zur fotovoltaischen Energieumwandlung umfasst, wobei die Solarzelle (5) elektrische Anschlüsse aufweist und diese mit den elektrischen Kontakten (6) im Rahmen (2) des Moduls (1) leitend verbunden ist.

3. Modul (1) nach Anspruch 1, **dadurch gekennzeichnet, dass** das Füllelement (4) mechanisch bearbeitbar, wie beispielsweise bohrbar oder sägbar, beschaffen sind.

4. Modul (1) nach einem der Ansprüche 1 bis 3, **dadurch gekennzeichnet, dass** die elektrischen Kontakte (6) des Moduls (1) miteinander durch Stromleiter verbunden sind, wobei diese Stromleiter vorzugsweise im Rahmen (2) des Moduls (1) integriert sind.

5. Modul (1) nach einem der Ansprüche 1 bis 4, **dadurch gekennzeichnet, dass** Einzelbefestigungselemente (7) zur unmittelbaren, lösbaren Befestigung des Moduls (1) an einer Unterkonstruktion (11), wie beispielsweise an einer Außenfläche eines Gebäudes, vorhanden sind.

6. Modul (1) nach einem der Ansprüche 1 bis 4, **dadurch gekennzeichnet, dass** die Doppelbefestigungselemente (6) zur unmittelbaren, lösbaren Befestigung des Moduls (1) mit einem benachbarten Modul (1) an einer einer Außenfläche eines Gebäudes eingerichtet sind.

7. Modul (1) nach einem der Ansprüche 5 oder 6, **dadurch gekennzeichnet, dass** Befestigungselemente zur verschiebbaren oder verdrehbaren Lagerung ausgebildet sind.

8. Modul (1) nach einem der Ansprüche 1 bis 7, **dadurch gekennzeichnet, dass** jedes Modul (1) mindestens eine Belüftungsöffnung (10) zur Hinterlüftung umfasst.

9. Modul (1) nach einem der Ansprüche 1 bis 8, **dadurch gekennzeichnet, dass** der Rahmen (2) des Moduls (1) aus einem Verbundwerkstoff, vorzugsweise aus einem Holz-Kunststoff-Verbundwerkstoff, beschaffen ist.

10. Modulsystem (9), **dadurch gekennzeichnet, dass** es zumindest zwei Module (1) nach einem der Ansprüche 1 bis 9 enthält.

11. Modulsystem (9) nach Anspruch 10, **dadurch gekennzeichnet, dass** zur Befestigung zumindest zwei Module (1) miteinander zusammengesteckt werden und jeweils zwei Module (1) an mindestens einem Befestigungselement einander teilweise überlappend gemeinsam befestigt sind.

12. Modulsystem (9) nach einem der Ansprüche 10 oder 11, **dadurch gekennzeichnet, dass** es unterschiedlich große Module (1) beinhaltet, wobei die Fläche der kleinen Module (1) in einem ganzzahligen Verhältnis, beispielsweise im Verhältnis 4:1 oder 3:1, vorzugsweise im Verhältnis 2:1, zur Fläche eines großen Moduls (1) steht.

## Claims

1. A module (1) of a photovoltaic system, which has a frame (2) for fastening and a filling element (4) and electrical contacts (6), at least two electrical contacts (6) being present in the frame (2) and it being possible to conductively connect the module (1) with one or more adjacent modules to these electrical contacts, **characterized in that** the module (1) is constructed in such a manner that a plurality of modules (1) can be mounted on a roof in a mutually overlapping manner, comparable to conventional roof tiles, wherein the frame (2) of a module (1) can be fastened directly to a substructure (11) using single fastening elements (7), wherein an adjacent module (1) can be fastened along one side, overlapping with a double fastening element (3) together with a module (1) located therebelow, to a substructure (11), wherein a double fastening element (3) is set up for direct, detachable fastening of a module (1) with an adjacent module (1) to the substructure (11), and wherein a ventilation opening (10) for rear ventilation remains exposed.

2. The module (1) according to Claim 1, **characterized in that** the filling element (4) comprises at least one solar cell (5) for photovoltaic energy conversion, wherein the solar cell (5) has electrical connections and the same is conductively connected to the electrical contacts (6) in the frame (2) of the module (1).

3. The module (1) according to Claim 1, **characterized in that** the filling element (4) is created such it they can be worked mechanically, such as for example can be drilled or sawed.

4. The module (1) according to one of Claims 1 to 3, **characterized in that** the electrical contacts (6) of the module (1) are connected to one another using conductors, wherein these conductors are preferably integrated in the frame (2) of the module (1).

5. The module (1) according to one of Claims 1 to 4, **characterized in that** single fastening elements (7) are present for the direct, detachable fastening of the module (1) to a substructure (11), such as for example to an external surface of a building.

6. The module (1) according to one of Claims 1 to 4, **characterized in that** the double fastening elements (6) are set up for the direct, detachable fastening of the module (1) with an adjacent module (1) to an external surface of a building.

7. The module (1) according to one of Claims 5 or 6, **characterized in that** fastening elements are constructed for displaceable or rotatable mounting.

8. The module (1) according to one of Claims 1 to 7, **characterized in that** each module (1) comprises at least one ventilation opening (10) for rear ventilation.

9. The module (1) according to one of Claims 1 to 8, **characterized in that** the frame (2) of the module (1) is created from a composite material, preferably from a wood-plastic composite material.

10. A module system (9), **characterized in that** it contains at least two modules (1) according to one of Claims 1 to 9.

11. The module system (9) according to Claim 10, **characterized in that**, for fastening, at least two modules (1) are plugged together and in each case two modules (1) are together fastened to at least one fastening element, at least partially overlapping one another.

12. The module system (9) according to one of Claims 10 or 11, **characterized in that** it contains differently sized modules (1), wherein the area of the small modules (1) is in a whole-number ratio, for example in the ratio 4:1 or 3:1, preferably in the ratio 2:1, to the area of a large module (1).

## Revendications

1. Module (1) d'un système photovoltaïque, qui présente un châssis (2) pour la fixation et un élément de remplissage (4) ainsi que des contacts électriques (6), dans lequel sur le châssis (2) au moins deux contacts électriques (6) sont présents et le module (1) peut être relié au niveau de ces contacts électriques avec un ou plusieurs modules voisins de manière conductrice, **caractérisé en ce que** le module (1)est configuré de telle sorte que plusieurs modules (1) peuvent être montés d'une manière se chevauchant l'un l'autre, comparables à des tuiles de toit traditionnelles, sur un toit, dans lequel le châssis (2) d'un module (1) peut être fixé avec des éléments de fixation individuels (7) directement sur un soubassement (11), dans lequel un module se raccordant (1) peut être fixé le long d'un côté se superposant à un élément de fixation double (3) en commun avec un module situant en dessous (1) sur un soubassement (11), dans lequel un élément de fixation double (3) est conçu en vue de la fixation amovible directe d'un module (1) avec un module voisin (1) sur le soubassement (11) et dans lequel une ouverture de remplissage (10) reste à découvert à des fins de ventilation par l'arrière.

2. Module (1) selon la revendication 1, **caractérisé en ce que** l'élément de remplissage (4) comprend au moins une cellule solaire (5) pour la conversion d'énergie photovoltaïque, dans lequel la cellule solaire (5) présente des raccords électriques et cette dernière est reliée de manière conductrice avec les contacts électriques (6) dans le châssis (2) du module (1).

3. Module (1) selon la revendication 1, **caractérisé en ce que** les éléments de remplissage (4) ont obtenu d'une manière usinable mécaniquement, comme par exemple pouvant être percés ou sciés.

4. Module (1) selon une des revendications 1 à 3, **caractérisé en ce que** les contacts électriques (6) du module (1) sont reliés les uns avec les autres par des conducteurs de courant, dans lequel des conducteurs de courant sont intégrés de préférence dans le châssis (2) du module (1).

5. Module (1) selon une des revendications 1 à 4, **caractérisé en ce que** des éléments de fixation individuels (7) pour la fixation amovible directe du module (1) sur un soubassement (11), comme par exemple sur une surface extérieure d'un bâtiment, sont présents.

6. Module (1) selon une des revendications 1 à 4, **caractérisé en ce que** les éléments de fixation double (6) pour la fixation amovible directe du module (1) avec un module voisin (1) sont réalisés sur une surface extérieure d'un bâtiment.

7. Module (1) selon une des revendications 5 ou 6, **caractérisé en ce que** des éléments de fixation pour le positionnement coulissant ou pivotant sont réalisés.

8. Module (1) selon une des revendications 1 à 7, **caractérisé en ce que** chaque module (1) comprend au moins une ouverture de ventilation (10) pour la ventilation par l'arrière.

9. Module (1) selon une des revendications 1 à 8, **caractérisé en ce que** le châssis (2) du module (1) est obtenu à partir d'un matériau composite, de préférence à partir d'un matériau composite bois-plastique.

10. Système modulaire (9), **caractérisé en ce qu'**il contient au moins deux modules (1) selon une des revendications 1 à 9.

11. Système modulaire (9) selon la revendication 10, **caractérisé en ce que** à des fins de fixation au moins deux modules (1) sont emboîtés l'un dans l'autre et respectivement deux modules (1) sont fixés en commun sur au moins un élément de fixation en se chevauchant partiellement l'un l'autre.

12. Système modulaire (9) selon une des revendications 10 ou 11, **caractérisé en ce qu'**il contient un module (1) de grandeur différente, dans lequel la surface du petit module (1) est en rapport avec la surface d'un module (1) dans un rapport de nombre entier, par exemple dans le rapport de 4:1 ou 3:1, de préférence dans le rapport 2:1.
